# EUROPÄISCHE PATENTANMELDUNG

(11) **EP 1 274 291 A2**
(43) Veröffentlichungstag der Anmeldung: **08.01.2003**
(21) Anmeldenummer: 02014814.4
(22) Anmeldetag: 02.07.2002
(51) Int. Cl.: H05K 7/20

(54) **Verfahren zur automatischen Projektierung der Steckplatzbelegung eines Racks einer speicherprogrammierbaren Steuerung**

(30) Priorität: 02.07.2001 DE 10131943
(71) Anmelder: SIEMENS AKTIENGESELLSCHAFT, 80333 München (DE)
(72) Erfinder: Abert, Michael, 76474 Au (DE); Burgard, Rolf, 76764 Rheinzabern (DE); Hodapp, Andreas, 76137 Karlsruhe (DE); Morio, Francis, 67360 Dieffenbach les Woerth (FR)

(57) **Zusammenfassung**

Verfahren zur automatischen Projektierung der Steckplatzbelegung eines Racks einer speicherprogrammierbaren Steuerung.

Es wird vorgeschlagen ein Verfahren zur automatischen Projektierung der Steckplatzbelegung eines Racks einer speicherprogrammierbaren Steuerung (SPS) sowie ein Computersystem mit einer darauf installierten Softwareanwendung zur Durchführung des Verfahrens.

Vorteil dieses Verfahrens ist es, dass der Projekteur der SPS bei der Auswahl und der Anordnung der Module im Rack unterstützt wird. Dabei kann er gewisse Randbedingungen definieren, wie beispielsweise die Verwendung eines bestimmten Moduls oder die Anordnung eines bestimmten Moduls auf einen bestimmten Steckplatz. Auf diese Weise können Fehler in der Modulanordnung bezüglich thermischer und anderer Gesichtspunkte nicht mehr auftreten.

## Beschreibung

Die Erfindung betrifft ein Verfahren zur automatischen Projektierung der Steckplatzbelegung eines Racks einer speicherprogrammierbaren Steuerung (SPS) sowie ein Computersystem mit einer darauf installierten Softwareanwendung zur Durchführung des Verfahrens.

Solche speicherprogrammierbaren Steuerungen sind in der Fertigungstechnik zur Steuerung einer Vielzahl von Prozessen verbreitet. Nach dem heutigen Stand der Technik werden in speicherprogrammierbaren Steuerungen die einzelnen Module auf einem Rack angeordnet oder zu einem Gesamtsystem zusammengesteckt. Hierbei unterliegt die Anordnung der einzelnen Module (Modultypen) bestimmten Regeln. So kann es beispielsweise möglich sein, dass eine mit einem Mikroprozessor versehene Zentraleinheit (CPU-Baugruppe) nur auf einen bestimmten Steckplatz gesteckt werden darf. Im Allgemeinen jedoch sind die Möglichkeiten der Anordnung der Module, z.B. Module in Form von Digitalein-/ausgabebaugruppen oder Kommunikationsbaugruppen, im Anwenderinteresse möglichst freizügig gehalten.

Die einzelnen Modultypen einer SPS haben unterschiedliche Werte für die Stromaufnahme und unterschiedliche Verlustleistungen und damit eine unterschiedliche Eigenerwärmung.

Gemäß des Standes der Technik erfolgt die Anordnung der Module durch den Projekteur der SPS. Thermische Gesichtspunkte zur Optimierung werden in der Regel nicht beachtet. Die Gesamtstromaufnahme wird vom Projekteur grob berechnet und danach die passende Stromversorgung ausgewählt. Je nach Sachkenntnis und Erfahrung des Projekteurs der SPS kommt es zu einer mehr oder weniger optimalen Anordnung der Module speziell unter dem Gesichtspunkt der optimalen Wärmeverteilung innerhalb der SPS. Fehler in der Anordnung der Module können zu einem Auftreten von ungewollten lokalen "Wärmenestern" führen, die die Lebensdauer der Module herabsetzen.

Es ist daher die Aufgabe der vorliegenden Erfindung, ein Verfahren zur automatischen Projektierung der Steckplatzbelegung eines Racks einer speicherprogrammierbaren Steuerung (SPS) zur Verfügung zu stellen. Des Weiteren ist es Aufgabe der vorliegenden Erfindung, ein Computersystem mit einer darauf installierten Softwareanwendung zur Durchführung des Verfahrens zur Verfügung zu stellen.

Die erfindungsgemäße Aufgabe wird gelöst, indem die Auswahl und die Anordnung der Module im Rack und/oder das Zusammenstecken der Module zu einem Gesamtsystem unter Berücksichtigung vom Benutzer und/oder andersseitig definierbarer Randbedingungen hard- und softwareseitig derart erfolgt, dass eine niedrigste erreichbare mittlere Betriebstemperatur der speicherprogrammierbaren Steuerung realisiert wird, und/oder dass eine optimale Wärmeverteilung innerhalb der speicherprogrammierbaren Steuerung erreicht wird, und/oder dass der Spannungsabfall auf der Rückwand des Racks minimiert wird, und/oder dass eine Verlustleistungs- und/oder Strombilanzierung durchgeführt wird.

Vorteil dieses Verfahrens ist es, dass der Projekteur der SPS bei der Auswahl und der Anordnung der Module unterstützt wird. Dabei kann er gewisse Randbedingungen definieren, wie beispielsweise die Verwendung eines bestimmten Moduls oder die Anordnung eines bestimmten Moduls auf einen bestimmten Steckplatz. Auf diese Weise können Fehler in der Modulanordnung bezüglich thermischer und anderer Gesichtspunkte nicht mehr auftreten.

In einer weiteren bevorzugten Ausführungsform des erfindungsgemäßen Verfahrens beruht die Auswahl der Stromversorgung auf dem Ergebnis der Verlustleistungs- und Strombilanzierung. Dies hat den Vorteil, dass die Stromversorgung stets optimal dimensioniert ist.

Gemäß einer anderen bevorzugten Ausführungsform werden bei der Durchführung des Verfahrens die folgenden Regeln berücksichtigt:
- Module mit festen Steckplatzregeln werden auf den zwingend vorgesehenen Steckplätzen angeordnet;
- Module mit der höchsten Verlustleistung werden nach Möglichkeit mit Leerplätzen umgeben, ansonsten mit Modulen mit niedriger Verlustleistung;
- Module mit der höchsten Stromaufnahme werden möglichst nah an der Stromversorgung angeordnet.
   Das erfindungsgemäße Computersystem mit einer darauf installierten Softwareanwendung zur Durchführung des Verfahrens zeichnet sich dadurch aus, dass es mindestens eine Eingabeeinheit zur Eingabe der vom Benutzer oder andersseitig definierbarer Randbedingungen aufweist, dass es mindestens eine Rechnereinheit zur Berechnung der Betriebstemperatur, und/oder zur Durchführung einer Verlustleistungs- und/oder Strombilanzierung der speicherprogrammierbaren Steuerung aufweist, und dass es mindestens eine Speichereinheit zur Speicherung der Daten bezüglich Verlustleistung, Stromaufnahme und Steckplatzregeln der für die speicherprogrammierbare Steuerung in Betracht kommenden Module aufweist, auf die die Softwareanwendung zurückgreifen kann.

In diesen Daten ist das vorhandene Expertenwissen und Katalogwissen bezüglich der SPS und der darin in Betracht kommenden Module vereint, so dass auch ein weniger qualifizierter Projekteur in die Lage versetzt wird, eine optimale Modulauswahl zu treffen und die Module optimal anzuordnen.

Modultemperaturen in einer SPS können beispielsweise im Bereich von zwischen 20 °C und 150 °C liegen. Durch das erfindungsgemäße Verfahren lassen sich beispielsweise ausgehend von Modultemperaturen von 100 °C (nicht optimiert) Betriebstemperaturen von 50 °C (optimiert) erreichen. Die durch das erfindungsgemäße Verfahren erreichbaren optimierten Betriebstemperaturen sind von der Art der verwendeten Module abhängig, so dass die nach Optimierung erreichte Temperaturerniedrigung ausgehend von der nicht optimierten Modulanordnung beispielsweise ≥ 50 °C aber auch ≤ 50 °C sein kann. Erfindungsgemäß können es auch ≤ 40 °C, ≤ 30 °C oder ≤ 20 °C sein. Gegebenenfalls kann die Temperaturerniedrigung nach Optimierung auch deutlich über 50 °C liegen.

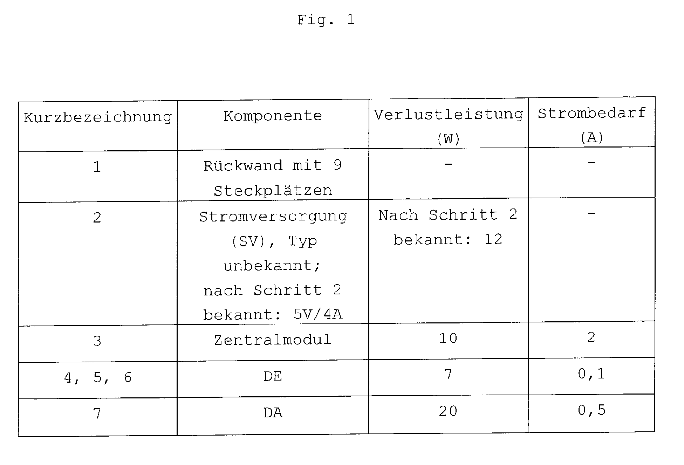

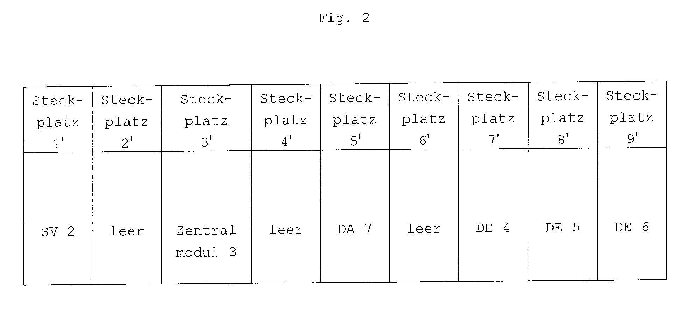

Im Folgenden wird die Erfindung anhand eines Ausführungsbeispiels unter Bezugnahme auf die Figuren 1 und 2 näher erläutert. Es zeigen:
- Fig. 1: eine Zusammenstellung der Module, aus denen eine SPS aufgebaut werden soll und
- Fig. 2: die optimale Anordnung der Module nach Durchführung des erfindungsgemäßen Verfahrens.
Die in Fig. 1 dargestellte Zusammenstellung der Module, aus denen eine SPS aufgebaut werden soll, enthält eine Rückwand (Backplane) mit neun Steckplätzen 1, eine Stromversorgung (SV) unbekannten Typs 2, ein mit einem Mikroprozessor versehenes Zentralmodul 3 mit einer Verlustleistung von 10 Watt und einem Strombedarf von 2A, drei Digitaleingabe-Module (DE) 4, 5, 6 mit einer Verlustleistung von je 7 Watt und einem Strombedarf von je 0,1A und ein Digitalausgabe-Modul (DA) 7 mit einer Verlustleistung von 20 Watt und einem Strombedarf von 0,5A.

Das erfindungsgemäße Verfahren führt folgende Schritte durch:
1. Ermittlung der Gesamtstromaufnahme I_{ges} = 2A + 3*0,1A + 0,5A = 2,8A.
2. Auswahl der geeigneten Stromversorgung aus dem im Computersystem gespeicherten Daten bezüglich Verlustleistung, Stromaufnahme und Steckplatzregeln der für die SPS in Betracht kommenden Module. Im gegebenen Beispiel wird die Stromversorgung SV mit 5V/4A gewählt.
3. Optimale Anordnung der Module mit dem in Fig. 2 dargestellten Ergebnis.
   Fig. 2 zeigt die optimale Anordnung der Module nach Durchführung des erfindungsgemäßen Verfahrens. Auf Steckplatz 1' wird die Stromversorgung SV 2 mit 5V/4A angeordnet, auf Steckplatz 3' der Mikroprozessor 3, auf Steckplatz 5' das Digitalausgabe-Modul 7, auf Steckplätzen 7', 8', 9' die Digitaleingabe-Module 4, 5, 6. Steckplätze 2', 4', 6' bleiben leer.

Gemäß dieser bevorzugten Ausführungsform des erfindungsgemäßen Verfahrens werden bei der Durchführung des Verfahrens die folgenden Regeln berücksichtigt:
- Module mit festen Steckplatzregeln werden auf den zwingend vorgesehenen Steckplätzen angeordnet (hier SV 2 auf Steckplatz 1);
- Module mit der höchsten Verlustleistung werden nach Möglichkeit mit Leerplätzen umgeben, ansonsten mit Modulen mit niedriger Verlustleistung;
- Module mit der höchsten Stromaufnahme werden möglichst nah an der Stromversorgung angeordnet, um den Spannungsabfall zu minimieren.

## Patentansprüche

1. Verfahren zur automatischen Projektierung der Steckplatzbelegung eines Racks einer speicherprogrammierbaren Steuerung (SPS), wobei Module in die Steckplätze des Racks steckbar sind, **dadurch gekennzeichnet, dass** eine Auswahl und eine Anordnung der Module im Rack und/oder das Zusammenstecken der Module zu einem Gesamtsystem unter Berücksichtigung vom Benutzer oder andersseitig definierbarer Randbedingungen hard- und softwareseitig derart erfolgt, dass eine niedrigste erreichbare mittlere Betriebstemperatur der SPS realisiert wird, und/oder dass eine optimale Wärmeverteilung innerhalb der SPS erreicht wird, und/oder dass der Spannungsabfall auf der Rückwand des Racks minimiert wird, und/oder dass eine Verlustleistungs- und/oder Strombilanzierung durchgeführt wird.

2. Verfahren nach Anspruch 1, **dadurch gekennzeichnet, dass** die Auswahl der Stromversorgung auf dem Ergebnis der Verlustleistungs- und Strombilanzierung beruht.

3. Verfahren nach Anspruch 1 oder Anspruch 2, **dadurch gekennzeichnet, dass** das Verfahren die nachfolgenden Schritte umfaßt:
a. Module mit festen Steckplatzregeln werden auf den zwingend vorgesehenen Steckplätzen angeordnet;
b. Module mit der höchsten Verlustleistung werden nach Möglichkeit mit Leerplätzen umgeben, ansonsten mit Modulen mit niedriger Verlustleistung;
c. Module mit der höchsten Stromaufnahme werden möglichst nah an der Stromversorgung angeordnet.

4. Computersystem mit einer darauf installierten Softwareanwendung zur Durchführung des Verfahrens nach einem der vorherstehenden Ansprüche, **dadurch gekennzeichnet, dass** es mindestens eine Eingabeeinheit zur Eingabe der vom Benutzer oder andersseitig definierbarer Randbedingungen aufweist, dass es mindestens eine Rechnereinheit zur Berechnung der Betriebstemperatur und/oder zur Durchführung einer Verlustleistungs- und/oder Strombilanzierung der speicherprogrammierbaren Steuerung aufweist, und dass es mindestens eine Speichereinheit zur Speicherung der Daten bezüglich Verlustleistung, Stromaufnahme und Steckplatzregeln der für die speicherprogrammierbare Steuerung in Betracht kommenden Module aufweist, auf die die Softwareanwendung zurückgreifen kann.
